# EUROPEAN PATENT APPLICATION

(11) **EP 1 867 915 A1**
(43) Date of publication of application: **19.12.2007**
(21) Application number: 05806804.0
(22) Date of filing: 18.11.2005
(51) Int. Cl.: F21V 8/00, G02F 1/13357, G02B 6/00, F21Y 101/02

(54) **PLANAR LIGHTING APPARATUS**

(30) Priority: 29.03.2005 JP 2005095061
(71) Applicant: MINEBEA Co., Ltd., Kitasaku-gun, Nagano-Ken 389-0293 (JP)
(72) Inventor: MIZUTANI, Hitoshi, Nagano 3890293 (JP)
(74) Representative: Schaad, Balass, Menzl & Partner AG
(86) International application number: PCT/JP2005/021258
(87) International publication number: WO 2006/103804

(57) **Abstract**

A planar lighting apparatus wherein thinning is promoted while improving luminance and luminance uniformity by easily and stably holding an LED on a light incoming plane of a light guide plate. The planar lighting apparatus (10) is provided with the light guide plate (2) and the LED (11) arranged on the light incoming plane (3) of the light guide plate (2). The light guide plate (2) is provided with a pressing section (5) which is integrally formed with the light guide plate (2) and faces the light incoming plane (3) at a prescribed interval (d). The LED (11) is sandwiched between the pressing section (5) and the light incoming plane (3), is in press contact with the light incoming plane (3) by elasticity of the pressing section (5), and correctly and stably keeps a position and a posture to the light incoming plane (3).

## Description

### Technical Field

The present invention relates to a side-light-type planar lighting apparatus and particularly to a planar lighting apparatus used as illuminating means of a liquid crystal display device.

### Background Art

A liquid crystal display device is widely used in display means or the like of electronic equipment at present but since the liquid crystal display device is not self-luminous, illuminating means for ensuring visibility at night and in dark places is needed. A planar lighting apparatus has been used as such illuminating means.

As a type of the planar lighting apparatus, a side-light-type planar lighting apparatus is widely used. The side-light-type planar lighting apparatus comprises a light guide plate with light transmittance, a rod-state light source arranged on a side end face of the light guide plate or one or more point-like light sources as basic elements. As a recent trend, in accordance with an increase in applications of planar lighting apparatuses to small-sized electronic equipment such as personal digital assistants, a planar lighting apparatus of the type provided with a point-like light source capable of simplification of a driving circuit is used, and a white LED (hereinafter also referred to simply as an LED) is frequently used as a point-like light source.

In the above side-light-type planar lighting apparatus, in order to promote higher brightness, it is important to realize close contact between a light-emitting face of the LED and a side end face (hereinafter referred to as light-incoming face) of a light guide plate on which the LED is arranged and to maintain high bonding efficiency between the LED and the light guide plate. Therefore, when the LED is arranged on the light-incoming face of the light guide plate, a circuit board such as a flexible print circuit board (hereinafter also referred to as FPC) on which the LED is mounted is affixed to the light guide plate using a double-sided adhesive tape, for example, by which a position and attitude of the LED with respect to the light-incoming face of the light guide plate is stably maintained in conventional practice.

On the other hand, there is a problem with this type of maintaining means in that close contact between the LED and the light guide plate may decrease due to displacement occurring at affixation between the FPC and the light guide plate, inclination when mounting the LED on the FPC and the like. Thus, in order to increase the bonding efficiency between the LED and the light guide plate, a planar lighting apparatus of the type that the LED is accommodated in a recess portion or the like formed on the light guide plate is proposed (See Patent Document 1 and Patent Document 2, for example).

Patent Document 1: Japanese Examined Utility Model Publication No. 4-14943 (Fig. 1)

Patent Document 2: Japanese Unexamined Patent Application Publication No. 2004-213943 (claim 1, claim 2, Fig. 1, Fig. 3)

### Disclosure of Invention

### Problems to be Solved by the Invention

However, with the planar lighting apparatus described in Patent Document 1, for example, as shown in a perspective view in Fig. 5, an LED 102 is simply accommodated and arranged in a fitting groove 113 formed on a light guide plate 103, and a light-emitting face 102a of the LED 102 is not in sufficiently close contact with the light-incoming face, which is an inner face of the fitting groove 113. In this regard, in the planar lighting apparatus described in Patent Document 2, as shown in a sectional view in Fig. 6, an LED 202 is accommodated in a frame-body holding portion 205 formed integrally with a light guide plate 201 and a back face 202b of the LED 202 is bonded and fixed to an inner face of the frame-body holding portion 205 by an adhesive g so that a light-emitting face 202a of the LED 202 is brought into contact with a light-incoming face 201a of a light guide plate 201. With this configuration, close contact between the light-incoming face 202a of the LED 202 and the light-incoming face 201a of the light guide plate 201 can be stably maintained, but an additional member such as the adhesive g and the like and new processes for filling and solidifying it are required, which might increase manufacturing costs of the planar lighting apparatus.

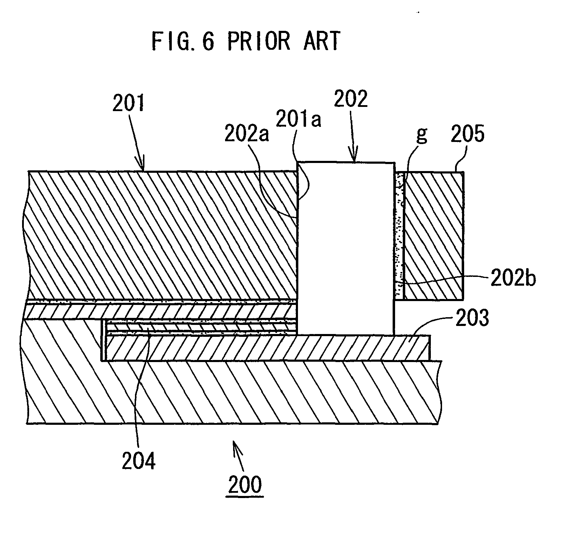

Also, in general, planar lighting apparatuses are requested to promote thinning while higher and more uniform brightness is achieved all the time, and since taking-out efficiency of light from an LED chip is improved and thickness for a sheath member portion is not needed any more, it is preferable to use an LED on which a translucent resin sealing the LED chip is formed so as to be exposed. However, in arrangement configuration of a planar lighting apparatus 200 shown in Fig. 6, use of such an LED incurs the following problem. That is, if the LED 202 does not have a sheath member and at least its entire front face 202a functions as a light-emitting face, outgoing light from the LED 202 includes light to be absorbed by an FPC 203 and a double-sided adhesive tape 204 or transmitted by them to become lost light, which lowers brightness due to generation of this lost light.

The present invention was made in view of the above problems and has an object to provide a planar lighting apparatus which promotes thinning while higher and more uniform brightness is achieved by maintaining an LED on a light-incoming face of a light guide plate easily and stably.

### Means for Solving the Problems

In order to solve the above problems, in a planar lighting apparatus according to the present invention provided with a light guide plate and an LED arranged on a light-incoming face of the light guide plate, the light guide plate has a pressing portion integrally formed with the light guide plate and opposite the light-incoming face with a predetermined gap, and the LED is held between the pressing portion and the light-incoming face and pressed into contact with the light-incoming face by elastic action of the pressing portion.

According to the present invention, by integrally forming the pressing portion with the light guide plate and arranging the LED in pressure contact with the light-incoming face of the light guide plate by the elastic action of the pressing portion, the LED is held in a proper attitude without having an inclination or the like with respect to the light-incoming face of the light guide plate and close contact between the light-emitting face and the light-incoming face of the light guide plate can be increased. And thus, the bonding efficiency between the LED and the light guide plate can be increased, which contributes to higher brightness of the planar lighting apparatus.

Moreover, in the present invention, the LED and the light guide plate preferably have mutually complementary convexoconcave structure at a contact portion between the LED and the light guide plate, by which when the LED is arranged on the light-incoming face of the light guide plate, the above convexoconcave structure is fitted to each other and the LED can be surely positioned at a predetermined position of the light-incoming face.

As above, in the planar lighting apparatus according to the present invention, by using a member such as a double-sided adhesive tape, an adhesive and the like, without requiring a process to fix a circuit board on which the LED is mounted or the LED itself to the light guide plate, the position and attitude of the LED to the light-incoming face of the light guide plate can be maintained properly and stably, by which higher brightness can be achieved without increasing the manufacturing costs of the planar lighting apparatus.

Also, in a mode of the present invention, the convexoconcave structure includes a projection portion formed on the light-emitting face of the LED and a cutaway portion formed on the light-incoming face of the light guide plate corresponding to the shape of the projection portion.

By this arrangement, the close contact between the light-emitting face of the LED and the light-incoming face of the light guide plate is further increased, and light emission distribution of the light incident to the light guide plate from the LED can be made equivalent to the light emission distribution of the single LED, which contributes to more uniform brightness of the planar lighting apparatus.

Also, in another mode of the present invention, the LED has a light-emitting portion in which a translucent resin sealing an LED chip is exposed, and the light-emitting portion is arranged without protruding in a direction crossing the light guide plate from the light-incoming face.

Since the translucent resin sealing the LED chip is exposed, the thickness for a sheath member portion is not increased but thinning of the planar lighting apparatus is promoted. Also, by arranging this type of LED without protruding its light-emitting portion in a direction crossing the light guide plate from the light-incoming face, generation of lost light can be restricted, and high taking-out efficiency of light provided at the LED with the sealing resin exposed can be effectively utilized so as to make brightness of the planar lighting apparatus higher.

Moreover, the LED is mounted on the circuit board and at the pressing portion of the light guide plate, a recess portion in which fixing means provided with an adhesive layer on both sides is accommodated may be formed so that the circuit board and the pressing means are fixed to each other by the fixing means.

By accommodating the fixing means such as the double-sided adhesive tape in the pressing portion with the recess portion formed and by fixing the circuit board on which the LED is mounted to the light guide plate by the fixing means, the LED is arranged without projecting the light-emitting portion in a direction crossing the light guide plate from the light-incoming face. At that time, since the light-emitting portion of the LED is not covered by the circuit board, generation of lost light due to absorption or the like into the circuit board and fixing means can be restricted, high taking-out efficiency of light provided at the LED with the sealing resin exposed is effectively utilized, and higher brightness of the planar lighting apparatus can be achieved. Also, by fixing the circuit board to the light guide plate, the position of the LED in a direction crossing the light guide plate can be accurately positioned.

### Advantages of the Invention

Since the present invention is configured as above, by maintaining the LED on the light-incoming face of the light guide plate easily and stably, thinning of the planar lighting apparatus can be promoted while higher and more uniform brightness is achieved.

### Brief Description of the Drawings

Fig. 1 is an exploded perspective view illustrating an essential part of a planar lighting apparatus in an embodiment of the present invention;
Fig. 2(a) is a plan view illustrating the planar lighting apparatus shown in Fig. 1 in a state where an LED is arranged, and Fig. 2(b) is an A-A sectional view thereof;
Fig. 3 is a side sectional view illustrating an essential part of a planar lighting apparatus in an embodiment of the present invention;
Figs. 4 are plan views illustrating a mode of a pressing portion of the planar lighting apparatus in an embodiment of the present invention, in which Fig. 4(a) shows a projection portion with the sectional outline in a triangular shape, Fig. 4(b) for a projection portion with the sectional outline in an arc shape, and Fig. 4(c) for a case having a plurality of projection portions with the sectional outline in a square shape;

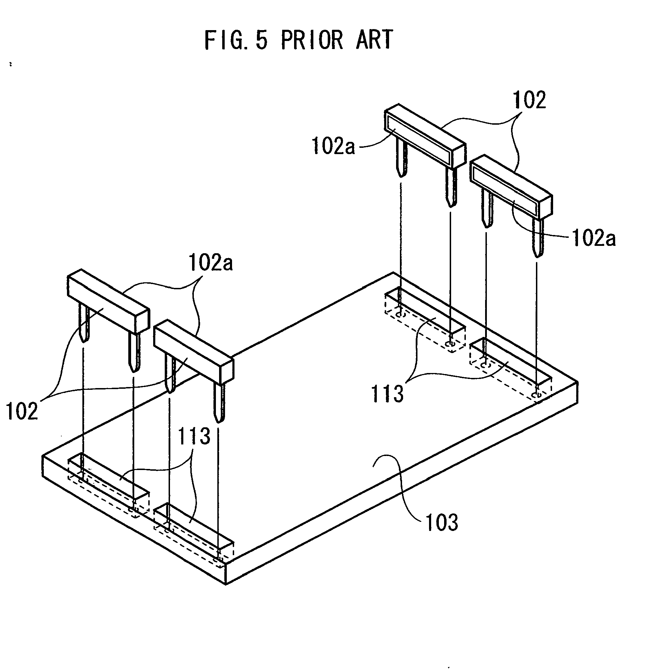

Fig. 5 is an exploded perspective view illustrating an example of configuration of a conventional planar lighting apparatus; and
Fig. 6 is a side sectional view illustrating another example of configuration of a conventional planar lighting apparatus.

### Reference Numerals

10, 20: Planar lighting apparatus
2, 21: Light guide plate
3: Light-incoming face
3a: Cutaway portion
5: Pressing portion
11: LED
13: Light emitting portion
13a: Projection portion
14: Light-emitting face

### Best Mode for Carrying Out the Invention

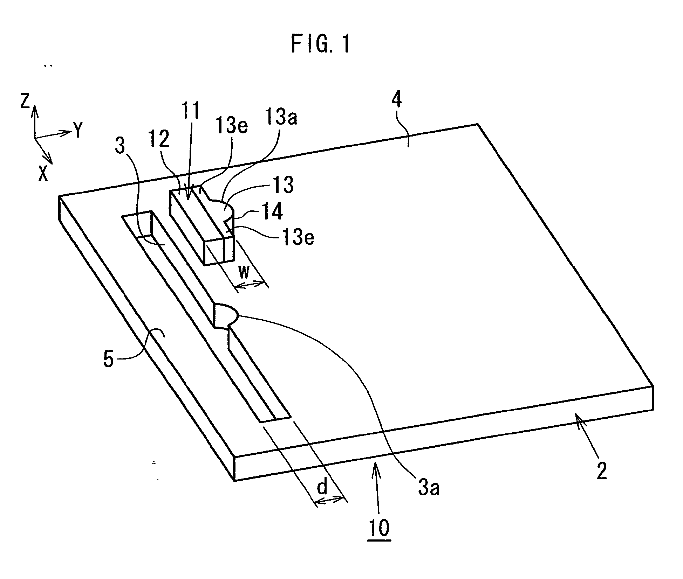

An embodiment of the present invention will be described below on the basis of the attached drawings, in which Figs. 1 to 4 are for explanation and do not necessarily reflect actual shapes and dimensions accurately.

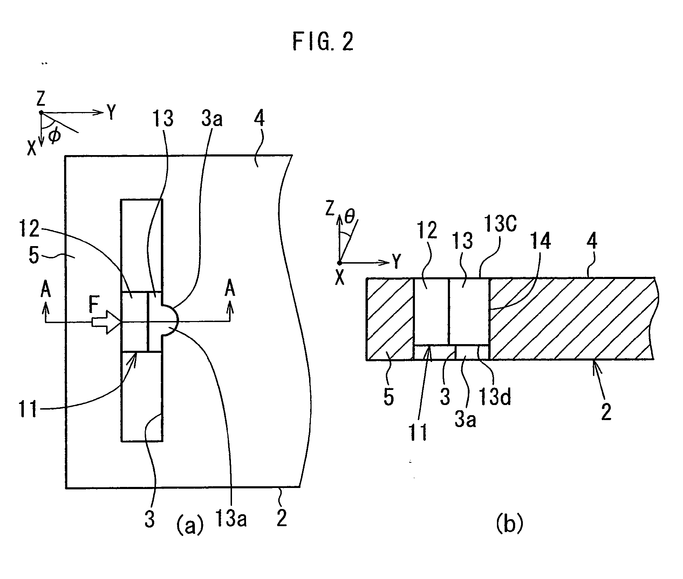

Figs. 1 and 2 are views illustrating an essential part of a planar lighting apparatus in an embodiment of the present invention, in which Fig. 1 is an exploded perspective view, Fig. 2(a) is a plan view illustrating a state where an LED is arranged, and Fig. 2(b) is an A-A sectional view of Fig. 2(a). A planar lighting apparatus 10 shown in Fig. 1 comprises a light guide plate 2 and an LED 11 arranged on a light-incoming face 3 of the light guide plate 2, and moreover, a pressing portion 5 opposite the light-incoming face 3 with a predetermined gap d is integrally formed. On the light-incoming face 3 of the light guide plate 2, a cutaway portion 3a following the shape of a projection portion 13a of the LED 11, which will be described, is formed.

In the following explanation, a longitudinal direction of the light-incoming face 3 is set as an X direction, a direction perpendicular to the light-incoming face 3 as a Y direction, and a direction crossing the light guide plate 2 (thickness direction of the light guide plate 2) as a Z direction, and a direction of the planar lighting apparatus 10 and its components are referred to on the basis of this coordinate system when necessary.

The LED 11 comprises a substrate portion 12 on which an LED chip (not shown) is mounted and a light-emitting portion 13 in which a translucent resin sealing an LED chip is exposed. The light-emitting portion 13 has a base portion 13e forming an outline of a substantial rectangular solid with the substrate portion 12 and a projection portion 13a constituted by a cylindrical face projecting forward (in the Y direction) from the base portion 13e, and a front face 14 (hereinafter referred to as light-emitting face) including this cylindrical face is arranged opposite the light-incoming face 3 of the light guide plate 2.

In this embodiment, the LED 11 preferably emits pseudo-white light by mixture of blue light emitted from the LED chip and yellow light emitted from a fluorescent substance absorbing the blue light and converting it to a long wavelength, and in this case, the light-emitting portion 13 made of a translucent resin may have a structure consisting of a layer in which yttrium, aluminum, and garnet (YAG) particles activated by cerium, which is a yellow luminescent material, are mixed in a hard silicon resin, and a transparent hard silicon resin layer is added on its periphery.

The light guide plate 2 is a plate-state light guide body made preferably by injection molding of a translucent resin such as acrylic resin, polycarbonate resin, amorphous polyolefin resin and the like, and the pressing portion 5 is integrally molded during the injection molding of the light guide plate 2. The above-mentioned resin materials are suitable as a material of a light guide plate from the viewpoint that they are excellent in terms of optical and molding characteristics and have relatively favorable elastic characteristics. For example, the bending elastic modulus, according to ASTM D-790 of acrylic resin, of polycarbonate resin is approximately 2,000 to 3,000 MPa in general, and the pressing portion 5 integrally molded with the light guide plate 2 has a considerable spring characteristic against flexural deformation caused by expansion of the gap d. Since the projection portion 13a of the LED 11 is constructed so as to have a cylindrical face, the cutaway portion 3a formed on the light-incoming face 3 of the light guide plate 2 also has a cylindrical face formed in substantially the same shape as that of the projection portion 13a of the LED 11.

In the light guide plate 2 shown in Fig. 1, the gap d between the pressing portion 5 and the light-incoming face 3 is formed to be slightly smaller than a thickness w in the Y direction of the rectangular solid made of the substrate portion 12 and the base portion 13e of the LED 11, and the LED 11 is held between the pressing portion 5 and the light-incoming face 3 while widening the gap d. At that time, a pressing force F schematically shown in Fig. 2(a) acts on the LED 11 by an elastic action according to deformation of the pressing portion 5, which fits the projection portion 13a of the light-emitting portion 13 in the cutaway portion 3a and brings it in contact with the light-incoming face 3 of the light guide plate 2. Dimensions of the pressing portion 5 such as width, length and the like are set as appropriate according to the elastic characteristics of the above-mentioned resin materials used for the light guide plate, the thickness of the light guide plate and the like.

As above, since the LED 11 is held between the pressing portion 5 and the light-incoming face 3 so that the light-emitting face 14 is brought into close contact with the light-incoming face 3, the LED 11 is not displaced in the Y direction, inclined in the azimuthal angle Φ direction shown in Fig. 2(a) or inclined in the polar angle θ direction shown in Fig. 2(b) but the position and attitude with respect to the light-incoming face 3 is maintained properly and stably. Moreover, in this embodiment, since the projection portion 13a of the LED 11 and the cutaway portion 3a of the light-incoming face 3 in the light guide plate 2 are fitted together in the complementary convexoconcave structure, the LED 11 is arranged at a predetermined position on the light-incoming face 3 without being displaced in the X direction.

In the present invention, the complementary convexoconcave structure at the contact portion between the LED 11 and the light guide plate 2 is not limited to a case of configuration by a cylindrical face such as the projection portion 13a and the cutaway portion 3a in this embodiment, but the projection portion of the LED may be constructed so as to have a cylindrical face and by adjusting a ratio between the projecting height and the radius as appropriate, the LED with a good balance between an amount of outgoing light forward and a wide-angle characteristic of the light emission distribution can be realized. Also, by accommodating and arranging this type of projection portion in the cutaway portion having a complementary shape with respect to the projection portion, the light emission distribution after light entrance into the light guide plate can be made equivalent to the light emission distribution of the single LED, which is advantageous for higher and more uniform brightness of the planar lighting apparatus 10.

Also, though not shown, the LED 11 is usually mounted on a circuit board such as a flexible print circuit board (FPC) and the like, and the circuit board is arranged along a major face 4 of the light guide plate 2, for example. However, according to the planar lighting apparatus of the present invention, since the LED 11 is positioned with respect to the light-incoming face 3 on the basis of the elastic action of the pressing portion 5 generated by holding the LED 11 by the pressing portion 5 and the light-incoming face 3 as mentioned above, without requiring a member and a process for fixing the circuit board on which the LED 11 is mounted to the light guide plate 2 or a member and a process for fixing the LED 11 itself to the light guide plate 2 as the conventional planar lighting apparatus, the LED 11 can be maintained on the light-incoming face 3 properly and stably.

Moreover, the LED 11 in this embodiment has a structure in which the light-emitting portion 13 is exposed as mentioned above, which contributes to thinning of the planar lighting apparatus. At the same time, by taking out the outgoing light from the LED chip from the entire light-emitting face 14 with high efficiency, higher brightness of the planar lighting apparatus can be promoted. In the planar lighting apparatus 10, as shown in Fig. 2(b), in order to effectively utilize the function of the LED 11, the LED 11 is arranged on the light-incoming face 3 without protruding the light-emitting portion 13 of the LED 11 from the light-incoming face 3 of the light guide plate 2 in the Z direction so that the outgoing light emitted from the entire light-emitting face 14 of the LED 11 is guided to the light guide plate 2 with efficiency. With this regard, the planar lighting apparatus according to the present invention not requiring fixing between the circuit board and the light guide plate in arrangement and fixation of the LED 11 is advantageous as compared with the structure of the conventional planar lighting apparatus as shown in Fig. 6, in which a part of the light-emitting face 202a of the LED 202 protrudes in the thickness direction of the light guide plate 201 from the light-incoming face 201a of the light guide plate 201 at least by a portion of the thickness of the double-sided tape 204, and the outgoing light from the protruding portion becomes lost light.

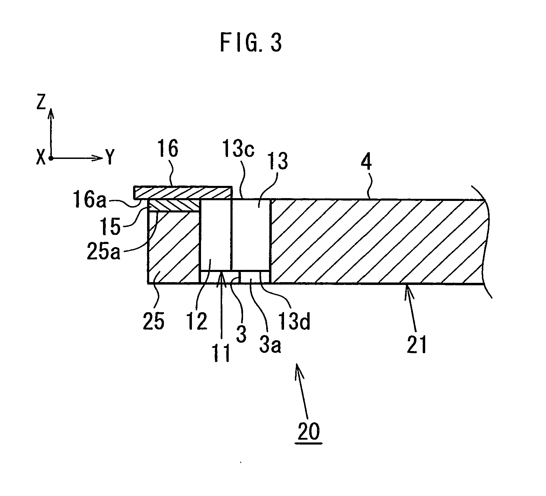

However, the planar lighting apparatus according to the present invention may have a structure in which the light guide plate and the circuit board on which the LED is mounted are fixed together using fixing means such as double-sided adhesive tape or the like, and such a preferred embodiment in that case will be described below referring to Fig. 3.

Fig. 3 is a side sectional view clearly showing an FPC 16, which is a circuit board on which the LED 11 is mounted, in an embodiment of the planar lighting apparatus according to the present invention. The planar lighting apparatus 20 shown in Fig. 3 is basically the same as the planar lighting apparatus 10 shown in Figs. 1 and 2 and has the same actions and effects but they are different from each other from the viewpoint that a recess portion 25a for accommodating fixing means 15 such as double-sided adhesive tape or the like is formed on a pressing portion 25 of the light guide plate 21. In the planar lighting apparatus 20, the LED 11 is mounted on the FPC 16 with an electrode, not shown, provided at the substrate portion 12, and the FPC 16 is fixed to the pressing portion 25 of a light guide plate 21 by the fixing means 15 accommodated in the recess portion 25a of the pressing portion 25.

As above, by fixing the FPC 16 to the light guide plate 21, the LED 11 can be positioned in the Z direction with respect to the light-incoming face 3 with more certainty. Also, in the planar lighting apparatus 20, the fixation between the FPC 16 and the light guide plate 21 is accomplished on the pressing portion 25 on the back face side of the LED 11, and no light is lost by absorption or the like of the fixing means 15. Moreover, since the fixing means 15 is accommodated in the recess portion 25a, the FPC 16 is arranged so that its mounting face 16a is substantially flush with the major face 4 of the light guide plate 21, and as mentioned above, the LED 11 is arranged without protruding the light-emitting portion 13 from the light-incoming face 3 of the light guide plate 21 in the Z direction.

Here, in the LED 11 in this embodiment, the outgoing light from the LED chip is taken out also from the side face other than the light-emitting face 14 of the light-emitting portion 13, and in order to effectively utilizes such outgoing light, a reflector may be laminated and arranged on either or both of an upper face 13c and a lower face 13d of the light-emitting portion 13. At that time, a mounting form of the LED 11 onto the FPC 16 is preferably such that, as shown in Fig. 3, only the substrate portion 12 is mounted on the FPC 16 and the light-emitting portion 13 is protruded from the outline of the FPC 16. By this arrangement, the reflector arranged on the upper face 13c of the LED 11 is directly opposite the upper face 13c, and loss of light due to absorption or the like of the FPC 16 does not occur but the outgoing light from the upper face 13c can be guided to the light guide plate 21 efficiently.

As such a reflector, a reflector in which a metal thin film with high reflectivity such as aluminum, silver and the like is formed on a thin resin substrate is preferable in terms of slimness and reflection characteristics but a reflector formed by applying a white or milky white paint on a thin resin base, a white resin board made of a resin mixed with a white pigment, or a metal thin plate with high reflectivity such as aluminum, silver and the like may be used. This mounting form of the LED onto the FPC is preferable also for a case where the FPC is not fixed to the light guide plate.

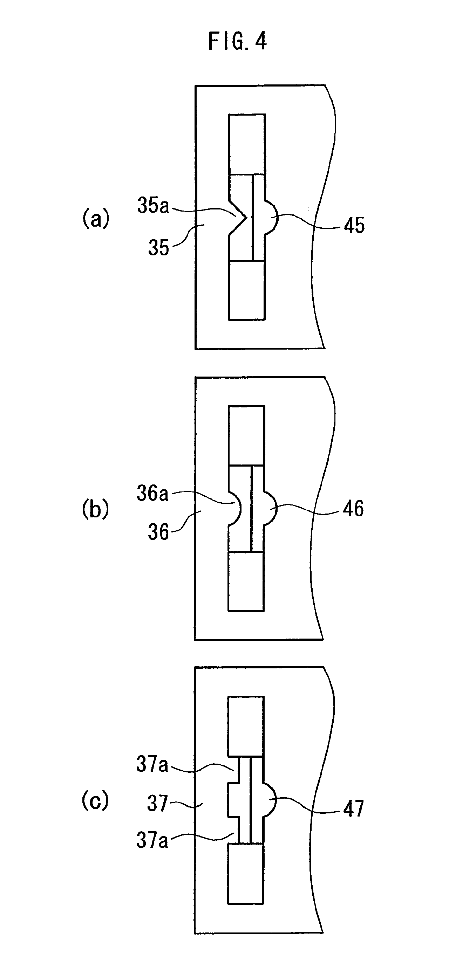

In the planar lighting apparatus according to the present invention, the convexoconcave structure formed at the contact portion between the LED and the light guide plate may be formed on the back faces of the pressing portion and the LED. Figs. 4(a) to 4(c) are plan views illustrating an example of such convexoconcave structure, in which Fig. 4(a) shows a pressing portion 35 having a projection portion 35a with the sectional outline in a triangular shape, Fig. 4(b) for a pressing portion 36 having a projection portion 36a with the sectional outline in an arc shape, and Fig. 4(c) for a pressing portion 37 having a plurality of projection portions 37a with the sectional outline in a square shape, respectively. In Figs. 4(a) to 4(c), on the back face sides of the LEDs 45, 46, 47, a recess portion having a complementary shape with each of the corresponding projection portions 35a, 36a, 37a is formed. By fitting the pressing portions 35 to 37 in the back faces of the LEDs 45 to 47 in this way, the degree of contact between the pressing portions 35 to 37 and the LEDs 45 to 47 is increased, and the elastic force by the elastic action of the pressing portions 35 to 37 can be transmitted to each of the LEDs 45 to 47 more accurately.

The preferred embodiments of the planar lighting apparatus according to the present invention have been described above using the LED 11 having the light-emitting portion 13 in which the translucent resin sealing the LED chip is exposed, but the planar lighting apparatus according to the present invention is also applied to the LED provided with a sheath member made of a white resin or the like. Also, the LED to be used does not have to have a projection portion on the light-emitting face but as shown in Fig. 4 in particular, when the pressing portion of the light guide plate and the back face side of the LED are to be fitted together, the LED is positioned in the X direction with the convexoconcave structure, and it may be configured that the light-emitting face side of the LED is made as a flat surface to be brought into pressure contact with and arranged on the flat light-incoming face. Also, in the planar lighting apparatus according to the present invention, the LED to be used may be arranged either on the short side or the long side of the light guide plate, and the number of LEDs to be held between the pressing portion and the light-incoming face may be plural.

## Claims

1. A planar lighting apparatus provided with a light guide plate and an LED arranged on a light-incoming face of the light guide plate, **characterized in that**
the light guide plate has a pressing portion formed integrally therewith and opposite said light-incoming face with a predetermined gap,
and the LED is held between the pressing portion and the light-incoming face and brought into pressure contact with the light-incoming face by an elastic action of the pressing portion.

2. The planar lighting apparatus according to claim 1, wherein said LED and said light guide plate have a mutually complementary convexoconcave structure at a contact portion between the LED and the light guide plate.

3. The planar lighting apparatus according to claim 2, wherein said convexoconcave structure includes a projection portion formed on the light-emitting face of said LED and a cutaway portion formed on the light-incoming face of said light guide plate corresponding to the shape of the projection portion.

4. The planar lighting apparatus according to any one of claims 1 to 3, wherein the LED has a light-emitting portion in which a translucent resin sealing an LED chip is exposed and is arranged without protruding the light-emitting portion in a direction crossing the light guide plate from the light-incoming face of the light guide plate.

5. The planar lighting apparatus according to claim 4, wherein the LED is mounted on a circuit board, and on the pressing portion on the light guide plate, a recess portion in which fixing means provided with an adhesive layer on both faces is accommodated is formed, and the circuit board and the pressing portion are fixed by the fixing means.
